# EUROPEAN PATENT SPECIFICATION

(11) **EP 3 196 924 B1**
(45) Date of publication and mention of the grant of the patent: **28.11.2018**
(21) Application number: 15823946.7
(22) Date of filing: 24.07.2015
(51) Int. Cl.: H01L 21/027, B29C 59/02, G03F 7/00

(54) **METHOD FOR MANUFACTURING MICROSCOPIC STRUCTURAL BODY**
VERFAHREN ZUR HERSTELLUNG MIKROSKOPISCHER STRUKTURKÖRPER
PROCÉDÉ DE FABRICATION DE CORPS STRUCTURAL MICROSCOPIQUE

(30) Priority: 25.07.2014 JP 2014152190
(43) Date of publication of application: 26.07.2017
(73) Proprietor: Soken Chemical & Engineering Co., Ltd., Toshima-ku Tokyo 171-8531 (JP)
(72) Inventor: MIYAZAWA, Yukihiro, Sayama-shi Saitama 350-1320 (JP)
(74) Representative: Gulde & Partner
(86) International application number: PCT/JP2015/071102
(87) International publication number: WO 2016/013655

(56) References cited:
- EP-A2- 1 903 392
- WO-A1-2013/154077
- JP-A- 2003 249 444
- JP-A- 2008 213 273
- JP-A- 2010 074 162
- KR-B1- 100 995 897
- US-A1- 2008 305 410
- US-A1- 2010 072 675
- US-A1- 2011 049 548

## Description

### Technical Field

The present invention relates to a method of manufacturing a microstructure using an imprinting technique.

### Background Art

The imprinting technique is a micromachining technique in which a mold having a micropattern is pressed against a resin layer, such as a liquid resin, on a transparent base, thereby transferring the mold pattern to the resin layer to obtain a microstructure. Such a micropattern ranges from patterns at the nanoscale, such as those at the 10 nm level, to patterns at approximately 100 µm. Microstructures thus obtained are used in various fields, such as semiconductor materials, optical materials, recording media, micromachines, biotechnology, and environmental technology.

Micropatterns to be formed in a microstructure include composite patterns and patterns with nested micro-shapes. For fabrication of such a pattern using a conventional technique, such as photolithography and electron beam lithography, a procedure is considered in which a primary pattern is fabricated by drawing, etching, and washing and then a secondary pattern is formed over the primary pattern by drawing, etching, and washing. Such a procedure is, however, takes very long and complex and condition setting is very difficult to fabricate a high quality mold.

In the technique of PTL 1, an etching mask of a single particle film is formed over a primary pattern and the primary pattern is etched using this mask to form a secondary pattern on the primary pattern surface. In PTL2, a mold comprising an etching mask is used to form a secondary pattern on the primary molded pattern

### Citation List

### Patent Literature

PTL 1: JP 2009-162831A,
PTL 2 : US2011/0049548 A1

### Summary of Invention

### Technical Problem

Even in the manufacturing method in PTL 1, however, it is difficult to optimize single particle film coating conditions and etching conditions.

The present invention has been made in view of such circumstances and is to provide a method of manufacturing a microstructure that enables convenient fabrication of a composite pattern and a nested structure.

### Solution to Problem

According to the present invention, a method of manufacturing a microstructure is provided that includes: forming, while pressing a first pattern of a first mold against a first transferred resin layer obtained by applying a first photocurable resin composition on a transparent base having a light shielding pattern, a first cured resin layer with the first pattern transferred thereto by irradiating the first transferred resin layer with an activation energy line through the first mold; and forming, while pressing a second pattern of a second mold against a second transferred resin layer obtained by applying a second photocurable resin composition on the first cured resin layer, a second cured resin layer having a level difference shape including a lower level area and a higher level area by irradiating the second transferred resin layer with an activation energy line using the light shielding pattern as a mask to cure the second transferred resin layer in a partial region, wherein at least one of the first and second patterns has a micro-shape.

The method of the present invention is based on the imprinting technique and the step of forming a micro-shape does not have to carry out drawing and etching. The method thus enables convenient fabrication of a composite pattern and a nested structure.

Various embodiments of the present invention are disclosed below as examples. The following embodiments may be combined with each other.

Preferably, both first and second patterns have a micro-shape, the lower level area includes a micro-shape with the first pattern transferred thereto, and the higher level area includes a micro-shape with the second pattern transferred thereto.

Preferably, the transparent base has flexibility.

Preferably, regions of the light shielding pattern and the lower level area are substantially identical.

Preferably, the first and second cured resin layers are formed without etching.

Preferably, the light shielding pattern is formed on a surface of the transparent base to apply the first photocurable resin composition.

Preferably, the light shielding pattern is formed flush with the transparent base.

Preferably, the microstructure is an imprinting mold, a stamper for microcontact printing, an optical sheet, a water repellent sheet, a hydrophilic sheet, or a cell culture sheet.

### Brief Description of Drawings

Fig. 1A to 1E illustrate a transparent base 1 used in in a first embodiment of the present invention, where Fig. 1A is a plan view, Fig. 1B is an A-A cross sectional view, and Fig. 1C through Fig. 1E illustrate other examples of a method of forming a light shielding pattern 3.
Fig. 2A to 2C are cross sectional views corresponding to Fig. 1B illustrating a first cured resin layer forming step in the first embodiment of the present invention.
Figs 3A to 3D are cross sectional views corresponding to Fig. 1B illustrating a second cured resin layer forming step in the first embodiment of the present invention.
Fig. 4A to 4C are cross sectional views corresponding to Fig. 1B illustrating a first cured resin layer forming step in a second embodiment of the present invention.
Fig. 5A to 5D are cross sectional views corresponding to Fig. 1B illustrating a second cured resin layer forming step in the second embodiment of the present invention.
Fig. 6A to 6D are cross sectional views corresponding to Fig. 1B illustrating a second cured resin layer forming step in a third embodiment of the present invention.
Fig. 7A to 7D are cross sectional views corresponding to Fig. 1B illustrating a second cured resin layer forming step in a fourth embodiment of the present invention.

### Description of Embodiments

Preferred embodiments of the present invention are specifically described below with reference to the drawings.

### 1. First Embodiment

A method of manufacturing a microstructure in the first embodiment of the present invention includes a first cured resin layer forming step and a second cured resin layer forming step. Each step is described below in detail.

### (1) First Cured Resin Layer Forming Step

### (1-1) First Transferred Resin Layer Forming Step

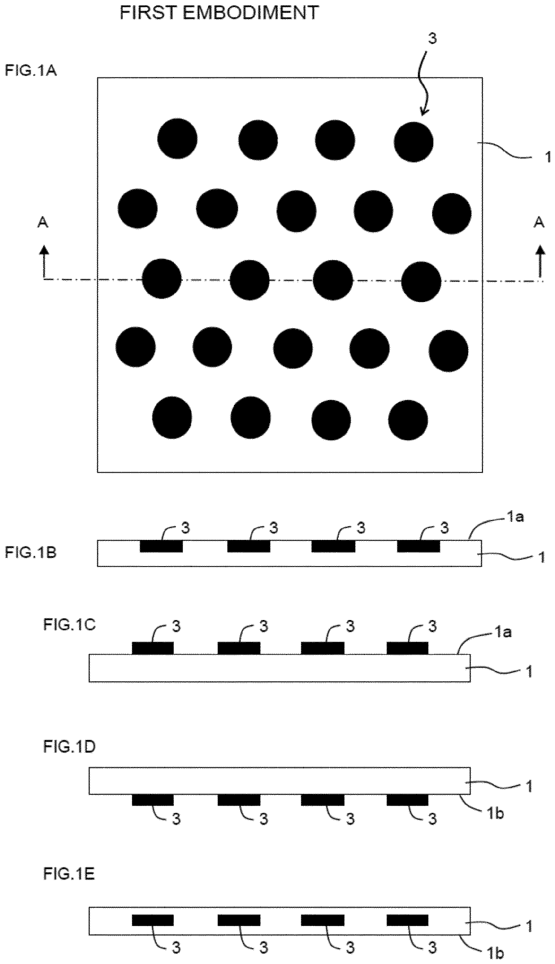

First, as illustrated in Fig. 1A, a first photocurable resin composition is applied on a transparent base 1 having a light shielding pattern 3 to form a first transferred resin layer 5.

### Transparent Base

The transparent base 1 is formed from a transparent material, such as a resin base and a quartz base. The material is preferably, but not particularly limited to, a resin base. This is because use of a resin base enables a microstructure obtained in a desired size (available in a large area) by the method of the present invention. A resin constituting the resin base is made of, for example, one selected from the group consisting of polyethylene terephthalate, polycarbonate, polyester, polyolefin, polyimide, polysulfone, polyether sulfone, cyclic polyolefin, and polyethylene naphthalate. The transparent base 1 preferably has flexibility, and when such a resin base is used, may be a laminate of same or different bases or a laminate of a resin composition in a film form on the resin base. The resin base preferably has a thickness ranging from 25 to 500 µm.

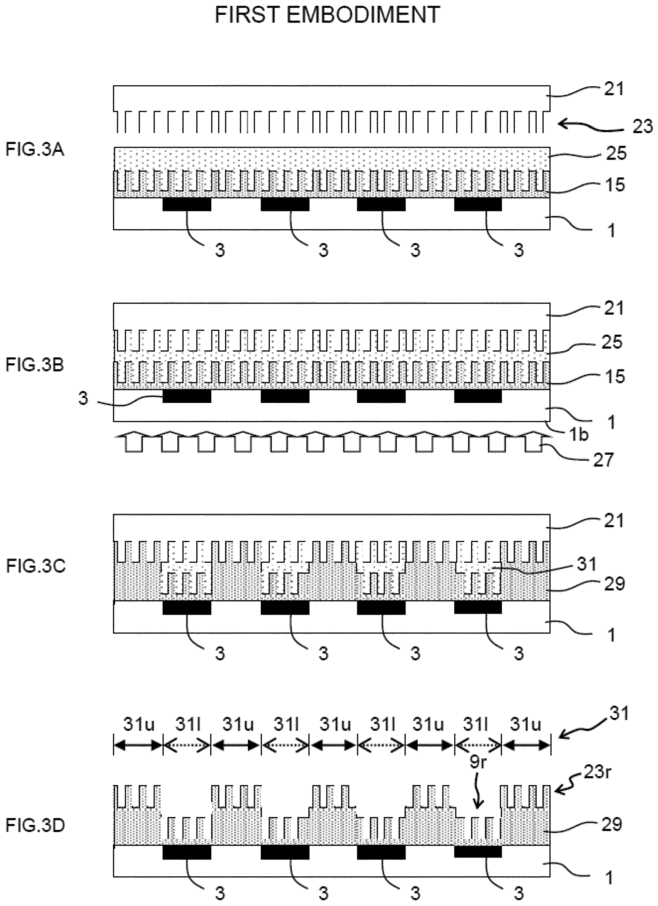

The light shielding pattern 3 provided in the transparent base 1 is a pattern utilized as a mask in the second cured resin layer forming step. As illustrated in Figs. 3B through 3D, a level difference shape 31 corresponding to the light shielding pattern 3 is formed in a second cured resin layer 29. The level difference shape 31 includes lower level areas 311 and higher level areas 31u. In an activation energy line irradiation step illustrated in Fig. 3B, a region where activation energy lines 27 are shielded by the light shielding pattern 3 becomes the lower level areas 311. "The activation energy line" is the generic name for energy lines capable of curing a photocurable resin composition, such as UV light, visible light, and electron beams. The shape of the light shielding pattern 3 includes, but not particularly limited to, a dot pattern as illustrated in Fig. 1A, a stripe pattern, and the like and preferably has intervals from 10 nm to 2 mm and more preferably from 10 nm to 20 µm.

The light shielding pattern 3 may be formed by patterning after deposition of a light shielding material (for example, a metal material, such as Cr) on the transparent base 1 by sputtering or formed by printing a pattern of a light shielding material by a method, such as ink jet printing and screen printing. As illustrated in Figs. 1B through 1C, the light shielding pattern 3 may be formed on the side of a surface 1a of the transparent base 1 to apply the first photocurable resin composition, or as illustrated in Fig. 1D, may be formed on a back side 1b of the transparent base 1. As illustrated in Fig. 1B, the light shielding pattern 3 may be formed flush with the transparent base 1, may be formed on a flat surface of the transparent base 1 as illustrated in Fig. 1C, or may be mounted in the transparent base 1 as illustrated in Fig. 1E.

### First Photocurable Resin Composition

The first photocurable resin composition constituting the first transferred resin layer 5 contains a monomer and a photoinitiator and is cured by irradiation with activation energy lines.

Examples of the monomer include photopolymerizable monomers to form a (meth)acrylic resin, a styrene resin, an olefin resin, a polycarbonate resin, a polyester resin, an epoxy resin, a silicone resin, and the like, and a photopolymerizable (meth)acrylic monomer is preferred. The term (meth)acrylic herein means methacrylic and/or acrylic and (meth)acrylate means methacrylate and/or acrylate.

The photoinitiator is a component to be added to accelerate polymerization of a monomer and is preferably contained 0.1 parts by mass or more based on 100 parts by mass of the monomer. The upper limit of the photoinitiator content is not particularly defined but, for example, 20 parts by mass based on 100 parts by mass of the monomer.

The first photocurable resin composition of the present invention may contain components, such as a solvent, a polymerization inhibitor, a chain transfer agent, an antioxidant, a photosensitizer, a filler, and a leveling agent, without affecting the properties of the first photocurable resin composition.

The first photocurable resin composition may be manufactured by mixing the above components in a known method. The first photocurable resin composition may be applied on the transparent base 1 by a method, such as spin coating, spray coating, bar coating, dip coating, die coating, and slit coating, to form the first transferred resin layer 5.

The first transferred resin layer 5 is generally a transparent resin layer and generally has a thickness from 50 nm to 1 mm and preferably from 500 nm to 500 µm. A thickness in this range facilitates imprinting.

### (1-2) Transfer and Curing Step

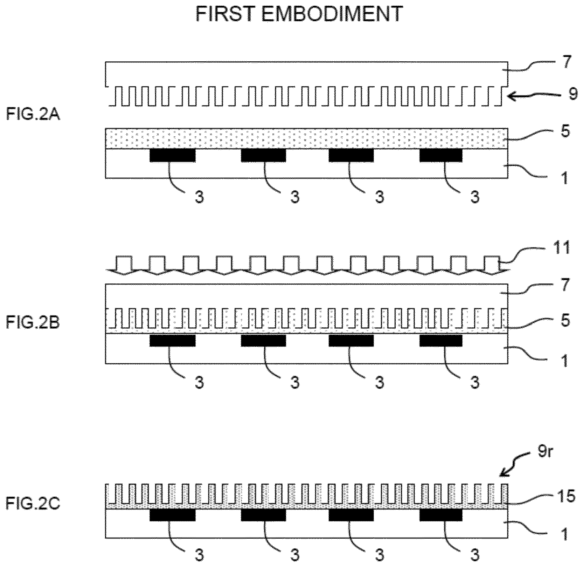

Next, as illustrated in Figs. 2A through 2C, while a first pattern 9 of a first mold 7 is pressed against the first transferred resin layer 5, the first transferred resin layer 5 is irradiated with an activation energy line through the first mold 7 to form a first cured resin layer 15 with the first pattern 9 transferred thereto.

The first mold 7 has the first pattern 9. In the present embodiment, the first pattern 9 is a micro-shape pattern with convexities and concavities repeated at certain intervals. The pattern preferably has intervals from 10 nm to 2 mm, a depth from 10 nm to 500 µm, and a transfer surface from 1.0 to 1.0 × 10⁶ mm² and more preferably intervals from 20 nm to 20 µm, a depth from 50 nm to 1 µm, and a transfer surface from 1.0 to 0.25 × 10⁶ mm². Such settings enable sufficient transfer of the micro-shape to the first transferred resin layer 5. Specific shapes of the convexities and concavities include moth eye patterns, lines, columns, monoliths, cones, polygonal pyramids, and microlens arrays. The intervals of the first pattern 9 are preferably smaller than the intervals of the light shielding pattern 3, more preferably from 0.01 to 0.5 times the intervals of the light shielding pattern 3, and even more preferably from 0.01 to 0.3 times. The first pattern 9 may be a micro-shape pattern with random convexities and concavities or may be a micro-shape pattern having a plurality of convexities and concavities.

The first mold 7 is formed from a transparent material, such as a resin base, a quartz base, and a silicone base, and may be formed from the same material as that of the transparent base 1.

The first mold 7 may be pressed against the first transferred resin layer 5 at a pressure that allows transfer of the shape of the first pattern 9 to the first transferred resin layer 5.

The first transferred resin layer 5 maybe irradiated with activation energy lines 11 at an integral to sufficiently cure the first transferred resin layer 5. The integral of light is, for example, from 100 to 10000 mJ/cm². The irradiation with the activation energy lines 11 cures the first transferred resin layer 5 to form, as illustrated in Fig. 2C, the first cured resin layer 15 with a first reverse pattern 9r formed by reversing the first pattern 9.

### (2) Second Cured Resin Layer Forming Step

### (2-1) Second Transferred Resin Layer Forming Step

Then, as illustrated in Fig. 3A, the second photocurable resin composition is applied on the first cured resin layer 15 to form a second transferred resin layer 25.

The above descriptions on the first photocurable resin composition apply to the second photocurable resin composition as long as not being inconsistent with the spirit. The type of second photocurable resin composition may be same as or different from that of the first photocurable resin composition. The second photocurable resin composition preferably fills gaps in the first reverse pattern 9r and has appropriate viscosity to allow formation of the second transferred resin layer 25 having a certain thickness over the first reverse pattern 9r. The second transferred resin layer 25 obtained by applying the second photocurable resin composition is generally a transparent resin layer and generally has a thickness over the first reverse pattern 9r from 50 nm to 1 mm and preferably from 500 nm to 500 µm. A thickness in this range facilitates imprinting.

### (2-2) Transfer and Curing Step

Then, as illustrated in Figs. 3A) through 3D, while a second pattern 23 of a second mold 21 is pressed against the second transferred resin layer 25, the second transferred resin layer 25 is irradiated with an activation energy line using the light shielding pattern 3 as a mask and the second transferred resin layer 25 is cured in a partial region to form the second cured resin layer 29 with the level difference shape 31 including lower level areas 311 and higher level areas 31u.

The above descriptions on the first mold 7 apply to the second mold 21 as long as not being inconsistent with the spirit. The first and second molds 7 and 21 may be identical molds or may be molds different from each other in material or pattern.

The second mold 21 does not have to transmit the activation energy lines 27. The second mold 21 may thus be formed from a metal material.

The second mold 21 may be pressed against the second transferred resin layer 25 at a pressure that allows transfer of the shape of the second pattern 23 to the second transferred resin layer 25.

The second transferred resin layer 25 may be irradiated with the activation energy lines 27 at an integral to sufficiently cure the second transferred resin layer 25. The integral of light is, for example, from 100 to 10000 mJ/cm². In the region not shielded by the light shielding pattern 3, the irradiation with the activation energy lines 27 cures the second photocurable resin composition filled in the gaps in the first reverse pattern 9r and cures the second transferred resin layer 25 with the second pattern 23 transferred thereto to form the second cured resin layer 29. In this step, in the regions where the second photocurable resin composition is cured, the higher level areas 31u of the level difference shape 31 illustrated in Fig. 3D are formed. In the higher level areas 31u, a second reverse pattern 23r obtained by reversing the second pattern 23 is formed. Meanwhile, in the regions where the activation energy lines 27 are shielded by the light shielding pattern 3 and the second photocurable resin composition is not cured, the lower level areas 311 are formed. In the lower level areas 311, the first reverse pattern 9r remains unchanged.

Then, as illustrated in Figs. 3C to 3D, the second mold 21 is removed and an uncured second photocurable resin composition 31 remained in the lower level areas 311 is removed by a solvent. The structure illustrated in Fig. 3D is thus obtained to complete manufacture of a microstructure.

The microstructure thus fabricated is applicable to imprinting molds, stampers for microcontact printing, optical sheets (antireflective sheets, hologram sheets, lens sheets, polarization separation sheets), water repellent sheets, hydrophilic sheets, cell culture sheets, molds for injection molding, microchips, hologram sheets, and the like.

The present embodiment may be carried out in the following modes.
- Although the first mold 7 in the above embodiment is not provided with a light shielding pattern, the first mold 7 may be provided with a light shielding pattern different from the light shielding pattern 3 and the first transferred resin layer 5 may be irradiated with the activation energy lines 11 through the first mold 7. In this case, it is possible to fabricate microstructures in more various shapes.
- A third cured resin layer may be formed by applying a photocurable resin composition on the second cured resin layer 29 to form a transferred resin layer and transferring another pattern to this transferred resin layer and curing the transferred resin layer in a partial region. Such a method enables fabrication of microstructures in even more various shapes.

### 2. Second Embodiment

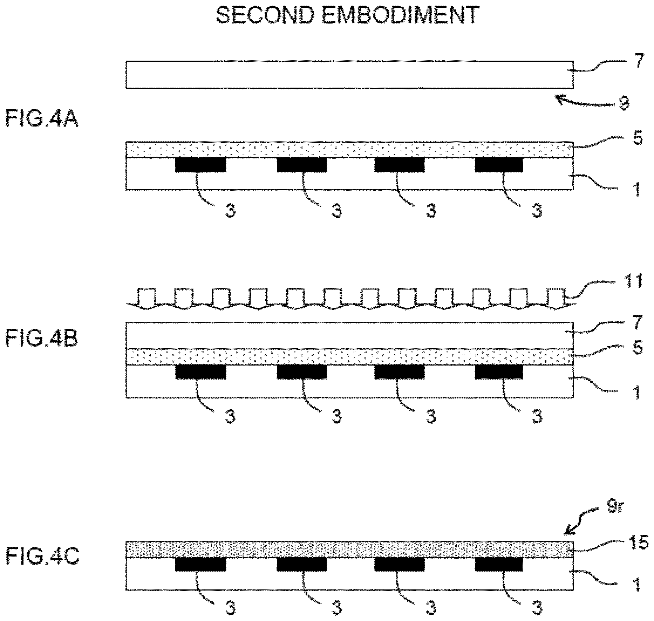

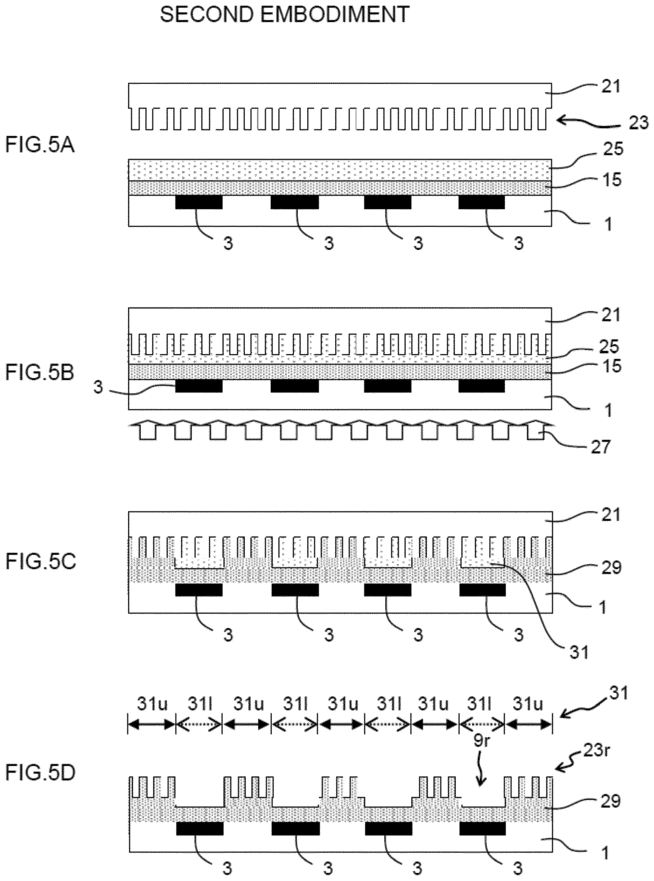

With reference to Figs. 4A to 4C and Figs. 5A through 5D, the second embodiment of the present invention is described. The present embodiment is similar to the first embodiment and is mainly different in that the first pattern 9 of the first mold 7 is not a micro-shape pattern but is a flat pattern (that is, a flat surface). The following description is mainly given to the difference.

First, as illustrated in Figs. 4A to 4C, while the first pattern 9 of the first mold 7 is pressed against the first transferred resin layer 5, the first transferred resin layer 5 is irradiated with the activation energy lines 11 through the first mold 7, thereby forming the first cured resin layer 15 as illustrated in Fig. 4C having the first reverse pattern 9r formed by reversing the first pattern 9. Since the first pattern 9 is a flat pattern, the first reverse pattern 9r is also a flat pattern and the first cured resin layer 15 surface is a flat surface.

Then, as illustrated in Figs. 5A to 5D, while the second pattern 23 of the second mold 21 is pressed against the second transferred resin layer 25 on the first cured resin layer 15, the second transferred resin layer 25 is irradiated with the activation energy lines 27 using the light shielding pattern 3 as a mask to cure the second transferred resin layer 25 in non-light shielding regions, and thus the second cured resin layer 29 having the level difference shape 31 is formed. Since the second pattern 23 is a micro-shape pattern, a micro-shape pattern formed by reversing the second pattern 23 is formed in the higher level areas 31u. Meanwhile, the lower level areas 311 remain as the flat patterns.

As just described, according to the present embodiment, a microstructure with a micro-shape pattern formed only in the higher level areas 31u is fabricated.

### 3. Third Embodiment

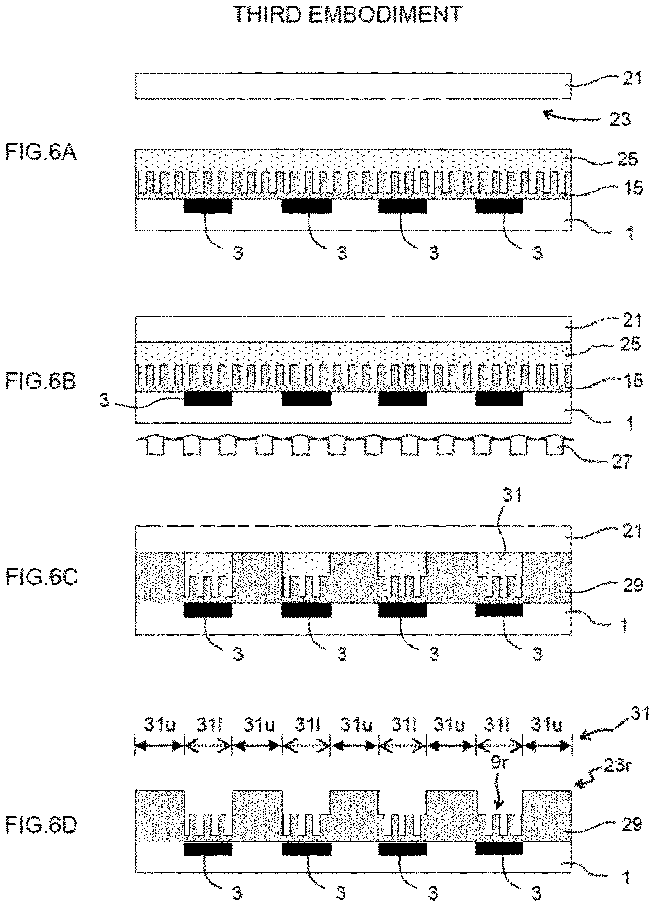

With reference to Figs. 6A to 6D, the third embodiment of the present invention is described. The present embodiment is similar to the first embodiment and is mainly different in that the second pattern 23 of the second mold 21 is not a micro-shape pattern but is a flat pattern (that is, a flat surface). The following description is mainly given to the difference.

First, as illustrated in Figs. 2A to 2C, the first cured resin layer 15 having the first reverse pattern 9r in a micro-shape is formed in the same method as that in the first embodiment.

Next, as illustrated in Figs. 6A to 6D, while the second pattern 23 of the second mold 21 is pressed against the second transferred resin layer 25 on the first cured resin layer 15, the second transferred resin layer 25 is irradiated with the activation energy lines 27 using the light shielding pattern 3 as a mask to cure the second transferred resin layer 25 in non-light shielding regions, and thus the second cured resin layer 29 having the level difference shape 31 is formed. Since the second pattern 23 is a flat pattern, a flat pattern is formed in the higher level areas 31u. Meanwhile, the lower level areas 311 remain formed with a micro-shape pattern.

As just described, according to the present embodiment, a microstructure with a micro-shape pattern formed only in the lower level areas 311 is fabricated.

### 4. Fourth Embodiment

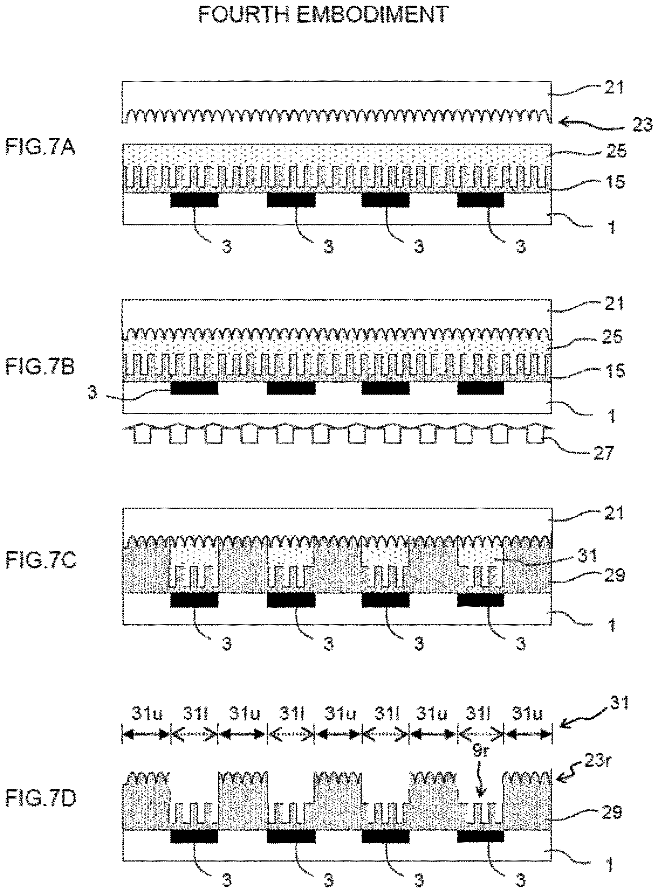

With reference to Figs. 7A to 7D, the fourth embodiment of the present invention is described. The present embodiment is similar to the first embodiment and is mainly different in that the second pattern 23 of the second mold 21 is a micro-shape pattern different from the first pattern 9 of the first mold 7. The following description is mainly given to the difference.

First, as illustrated in Figs. 2A to 2C, the first cured resin layer 15 having the first reverse pattern 9r in a micro-shape is formed in the same method as the first embodiment. The first reverse pattern 9r is a linear pattern.

Next, as illustrated in Figs. 7A to 7D, while the second pattern 23 of the second mold 21 is pressed against the second transferred resin layer 25 on the first cured resin layer 15, the second transferred resin layer 25 is irradiated with the activation energy lines 27 using the light shielding pattern 3 as a mask to cure the second transferred resin layer 25 in non-light shielding regions, and thus the second cured resin layer 29 having the level difference shape 31 is formed. Since the first and second patterns 9 and 23 are respectively a linear pattern and a reverse pattern of a moth eye pattern, a moth eye pattern is formed in the higher level areas 31u and a linear pattern remains formed in the lower level areas 311.

As just described, according to the present embodiment, a microstructure with patterns formed differently in interval and shape is fabricated in the lower level areas 311 and the higher level areas 31u.

In addition, the microstructures obtained in the above first through fourth embodiments may be used as the first mold 7 and the second mold 21, and particularly using the microstructures obtained in the second and fourth embodiments, a microstructure formed with three patterns is obtained.

### Reference Signs List

1: Transparent Base, 3: Light Shielding Pattern, 5: First Transferred Resin Layer, 7: First Mold, 11, 27: Activation Energy Line, 15: First Cured Resin Layer, 21: Second Mold, 25: Second Transferred Resin Layer, 29: Second Cured Resin Layer

## Claims

1. A method of manufacturing a microstructure, comprising:
forming, while pressing a first pattern of a first mold (7) against a first transferred resin layer (5) obtained by applying a first photocurable resin composition on a transparent base (1) having a light shielding pattern (3), a first cured resin layer with the first pattern transferred thereto by irradiating the first transferred resin layer with an activation energy line (11) through the first mold; and
forming, while pressing a second pattern of a second mold (21) against a second transferred resin layer (25) obtained by applying a second photocurable resin composition on the first cured resin layer, a second cured resin layer having a level difference shape including a lower level area and a higher level area by irradiating the second transferred resin layer with an activation energy line (27) using the light shielding pattern as a mask to cure the second transferred resin layer in a partial region, wherein
at least one of the first and second patterns has a micro-shape.

2. The method of Claim 1, wherein
both first and second patterns have a micro-shape,
the lower level area includes a micro-shape with the first pattern transferred thereto, and
the higher level area includes a micro-shape with the second pattern transferred thereto.

3. The method of Claim 1 or 2, wherein the transparent base has flexibility.

4. The method of any one of Claims 1 to 3, wherein regions of the light shielding pattern and the lower level area are substantially identical.

5. The method of any one of Claims 1 to 4, wherein the first and second cured resin layers are formed without etching.

6. The method of any one of Claims 1 to 5, wherein the light shielding pattern is formed on a surface of the transparent base to apply the first photocurable resin composition.

7. The method of Claim 6, wherein the light shielding pattern is formed flush with the transparent base.

8. The method of any one of Claims 1 to 7, wherein the microstructure is an imprinting mold, a stamper for microcontact printing, an optical sheet, a water repellent sheet, a hydrophilic sheet, or a cell culture sheet.

## Patentansprüche

1. Verfahren zur Herstellung einer Mikrostruktur, umfassend:
Ausbilden - unter Drücken eines ersten Musters einer ersten Form (7) gegen eine erste transferierte Harzschicht (5), die durch Aufbringen einer ersten lichthärtbaren Harzzusammensetzung auf eine transparente Basis (1), die ein Lichtabschirmmuster (3) aufweist, erhalten wurde - einer ersten gehärteten Harzschicht, wobei das erste Muster auf diese transferiert wird, indem die erste transferierte Harzschicht durch die erste Form hindurch mit einer Aktivierungsenergielinie (11) bestrahlt wird; und
Ausbilden - unter Drücken eines zweiten Musters einer zweiten Form (21) gegen eine zweite transferierte Harzschicht (25), die durch Aufbringen einer zweiten lichthärtbaren Harzzusammensetzung auf die erste gehärtete Harzschicht erhalten wurde - einer zweiten gehärteten Harzschicht, die eine Form mit Höhendifferenz aufweist, umfassend einen Bereich mit niedrigerer Höhe und einen Bereich mit höherer Höhe, durch Bestrahlen der zweiten transferierten Harzschicht mit einer Aktivierungsenergielinie (27) unter Verwendung des Lichtabschirmmusters als Maske, um die zweite transferierte Harzschicht in einem Teilbereich zu härten, wobei
das erste oder/und zweite Muster eine Mikroform aufweist/aufweisen.

2. Verfahren nach Anspruch 1, wobei
sowohl das erste als auch das zweite Muster eine Mikroform aufweisen,
der Bereich mit niedrigerer Höhe eine Mikroform mit dem darauf transferierten ersten Muster umfasst und
der Bereich mit höherer Höhe eine Mikroform mit dem darauf transferierten zweiten Muster umfasst.

3. Verfahren nach Anspruch 1 oder 2, wobei die transparente Basis Flexibilität aufweist.

4. Verfahren nach einem der Ansprüche 1 bis 3, wobei Bereiche des Lichtabschirmmusters und der Bereich mit niedrigerer Höhe im Wesentlichen identisch sind.

5. Verfahren nach einem der Ansprüche 1 bis 4, wobei die erste und zweite gehärtete Harzschicht ohne Ätzen ausgebildet werden.

6. Verfahren nach einem der Ansprüche 1 bis 5, wobei das Lichtabschirmmuster auf einer Oberfläche der transparenten Basis ausgebildet ist, um die erste lichthärtbare Harzzusammensetzung aufzubringen.

7. Verfahren nach Anspruch 6, wobei das Lichtabschirmmuster mit der transparenten Basis fluchtend ausgebildet ist.

8. Verfahren nach einem der Ansprüche 1 bis 7, wobei die Mikrostruktur eine Druckform, ein Stempel für Mikrokontaktdrucken, eine optische Folie, eine wasserabweisende Folie, eine hydrophile Folie oder eine Zellkulturfolie ist.

## Revendications

1. Procédé de fabrication d'une microstructure comprenant :
la formation, tout en mettant sous pression un premier motif d'un premier moule (7) contre une première couche d'une résine transférée (5) obtenue par application d'une première composition résinique photodurcissable sur une base transparente (1) dotée d'un motif de blocage de la lumière (3), d'une première couche d'une résine durcie sur laquelle le premier motif a été transféré par irradiation de la première couche de la résine transférée au moyen d'une source d'énergie d'activation (11) au travers du premier moule ; et
la formation, tout en mettant sous pression un deuxième motif d'un deuxième moule (21) contre une deuxième couche d'une résine transférée (25) obtenue par application d'une deuxième composition résinique photodurcissable sur la première couche de la résine durcie, une deuxième couche d'une résine durcie ayant une forme différente en termes de niveau, y compris une zone de niveau moindre et une zone de niveau plus élevé, par irradiation de la deuxième couche de la résine transférée au moyen d'une source d'énergie d'activation (27) en utilisant le motif de blocage de la lumière comme masque pour produire le durcissement de la deuxième couche de la résine transférée dans une région partielle, où
au moins un parmi les premier et deuxième motifs a une micro-forme.

2. Procédé de la revendication 1, où :
le premier et le deuxième motifs ont tous deux une micro-forme,
la zone de niveau moindre inclut une micro-forme sur laquelle le premier motif est transféré et
la zone de niveau plus élevé inclut une micro-forme sur laquelle le deuxième motif est transféré.

3. Procédé de la revendication 1 ou 2, où la base transparente présente une flexibilité.

4. Procédé de l'une quelconque des revendications 1 à 3, où les régions dotées du motif de blocage de la lumière et la zone de niveau moindre sont essentiellement identiques.

5. Procédé de l'une quelconque des revendications 1 à 4, où les première et deuxième couches de résine durcie sont formées sans gravure.

6. Procédé de l'une quelconque des revendications 1 à 5, où le motif de blocage de la lumière est formé sur une surface de la base transparente pour appliquer la première composition résinique photodurcissable.

7. Procédé de la revendication 6, où le motif de blocage de la lumière est formé à affleurement de la base transparente.

8. Procédé de l'une quelconque des revendications 1 à 7, où la microstructure est un moule d'impression, un tampon pour impression par microcontact, une feuille optique, une feuille hydrofuge, une feuille hydrophile ou une feuille de culture de cellules.
